Europäisches Patentamt

European Patent Office  (11) Numéro de publication : **0 031 626**

Office européen des brevets  **B1**

(12)  **FASCICULE DE BREVET EUROPÉEN**

(19)

(45) Date de publication du fascicule du brevet :
22.06.83

(21) Numéro de dépôt : **80201220.3**

(22) Date de dépôt : **19.12.80**

(51) Int. Cl.³ : **H 03 K 17/725**

(54) Dispositif de commande de la gâchette d'un interrupteur semiconducteur d'un système bidirectionnel.

(30) Priorité : **28.12.79 FR 7931968**

(43) Date de publication de la demande :
**08.07.81 Bulletin 81/27**

(45) Mention de la délivrance du brevet :
**22.06.83 Bulletin 83/25**

(84) Etats contractants désignés :
**BE DE FR GB NL**

(56) Documents cités :
**FR A 1 517 218**
**FR A 2 400 286**
**US A 3 940 634**
**ELECTRONIQUE INDUSTRIELLE, no. 130, janvier-février 1970 PARIS (FR) TERREUX « Temporisations pour éclairage des cages d'escalier, moteurs et ventilateurs », pages 37-39**

(73) Titulaire : **R.T.C. LA RADIOTECHNIQUE-COMPELEC**
Société anonyme dite:
**51 rue Carnot BP 301**
**F-92156 Suresnes (FR)**
**FR**
**N.V. Philips' Gloeilampenfabrieken**
**Groenewoudseweg 1**
**NL-5621 BA Eindhoven (NL)**
**BE DE GB NL**

(72) Inventeur : **Six, Jean-Claude**
**Société Civile S.P.I.D. 209, rue de l'Université**
**F-75007 Paris (FR)**
Inventeur : **Coulmance, Jean-Pierre**
**Société Civile S.P.I.D. 209, rue de l'Université**
**F-75007 Paris (FR)**

(74) Mandataire : **Pinchon, Pierre et al**
**Société Civile S.P.I.D. 209 rue de L'Université**
**F-75007 Paris (FR)**

## Dispositif de commande de la gâchette d'un interrupteur semiconducteur d'un système bidirectionnel

La présente invention concerne un dispositif de commande de la gâchette d'un interrupteur semiconducteur d'un système bidirectionnel, une borne de sortie du dispositif de commande étant connectée à la gâchette de l'interrupteur semiconducteur, l'interrupteur étant disposé en série avec une charge alimentée par le secteur, ledit dispositif comportant un générateur d'impulsions dont la sortie est connectée à la gâchette de l'interrupteur semiconducteur, un circuit interrupteur qui permet de commander la mise en fonctionnement du générateur d'impulsions, et un circuit de redressement de courant à accumulateur d'énergie fournissant une tension continue d'alimentation au générateur d'impulsions et au circuit interrupteur, une première borne d'entrée du circuit de redressement de courant étant couplée à un premier pôle du système bidirectionnel, tandis qu'une deuxième borne d'entrée du circuit de redressement de courant est connectée à un deuxième pôle du système bidirectionnel.

Le dispositif de commande selon l'invention peut être avantageusement utilisé, par exemple, dans tout système électronique de commutation du courant d'alimentation de charges électriques branchées sur le réseau.

Les dispositifs de ce type existant actuellement, comme celui décrit dans le brevet américain n° 3 940 634, comportent un circuit d'excitation de la gâchette de l'interrupteur semiconducteur constitué le plus souvent par un générateur d'impulsions et un circuit interrupteur permettant à l'utilisateur de mettre en fonctionnement ou hors fonctionnement le générateur d'impulsions et donc de commander la fermeture et l'ouverture du système bidirectionnel. L'alimentation du circuit interrupteur et du générateur d'impulsions est assuré, en général, par un circuit de redressement de courant fournissant une tension continue à partir du secteur. Dans la plupart des réalisations, le circuit de redressement de courant est muni d'un accumulateur d'énergie, généralement un condensateur électrochimique, qui prélève sur le réseau, lorsque le système bidirectionnel est non-conducteur, autour du zéro du courant-secteur, l'énergie nécessaire à l'alimentation du générateur d'impulsions et du circuit interrupteur pendant tout le temps où le système bidirectionnel est en conduction.

Le plus souvent, la charge du condensateur électrochimique a lieu pendant une durée fixée une fois pour toutes par construction. Dans la plupart des cas, cette durée pendant laquelle le système bidirectionnel est bloqué est surdimensionnée afin d'assurer en toutes circonstances une charge suffisante de l'élément accumulateur d'énergie, en particulier lors de fluctuations ou d'interruptions brèves de la tension-secteur.

Ce mode de fonctionnement présente l'inconvénient d'une consommation excessive et inutile du circuit de redressement de courant au détriment de la charge, du fait du surdimensionnement de la durée d'ouverture du système bidirectionnel et de la présence, à l'entrée du circuit de redressement de courant, d'une résistance de valeur élevée dont le rôle est d'abaisser le niveau de la tension-secteur avant redressement. D'autre part, la charge du condensateur électrochimique ayant lieu pendant une durée fixe, indépendante des fluctuations de la tension-secteur, le circuit de redressement de courant ne peut fournir une tension continue suffisamment stable pour pouvoir alimenter des circuits complexes tels que les circuits à mémoire.

La présente invention se donne pour but de remédier à l'ensemble de ces inconvénients. Elle est basée sur l'idée que l'on pourrait utiliser un système de régulation permettant d'une part de mettre hors fonctionnement le générateur d'impulsions, et donc de maintenir le système bidirectionnel non-conducteur, tant que le niveau de la tension continue d'alimentation est inférieure à un seuil prédéterminé et, d'autre part, d'arrêter la charge de l'élément accumulateur d'énergie au moment où ladite tension continue d'alimentation a atteint la valeur du seuil. Ainsi, la durée d'ouverture du triac serait variable mais strictement limitée au temps nécessaire pour charger suffisamment l'élément accumulateur d'énergie.

En effet, selon la présente invention, un dispositif de commande de la gâchette d'un interrupteur semiconducteur d'un système bidirectionnel, une borne de sortie du dispositif de commande étant connectée à la gâchette de l'interrupteur semiconducteur, l'interrupteur étant disposé en série avec une charge alimentée par le secteur, ledit dispositif comportant un générateur d'impulsions dont la sortie est connectée à la gâchette de l'interrupteur semiconducteur, un circuit interrupteur qui permet de commander la mise en fonctionnement du générateur d'impulsions, et un circuit de redressement de courant à accumulateur d'énergie fournissant une tension continue d'alimentation au générateur d'impulsions et au circuit interrupteur, une première borne d'entrée du circuit de redressement de courant étant couplée à un premier pôle du système bidirectionnel, tandis qu'une deuxième borne d'entrée du circuit de redressement de courant est connectée à un deuxième pôle du système bidirectionnel, est notamment remarquable en ce que le dispositif comporte un circuit de comparaison du niveau de la tension continue d'alimentation à la valeur d'une tension de référence, et un moyen de blocage des signaux appliqués à la gâchette de l'interrupteur semiconducteur quand la tension continue d'alimentation est inférieure à la tension de référence.

Le circuit de comparaison agit comme détecteur de seuil ; il délivre à une entrée du moyen de blocage un signal de mise hors fonctionnement du générateur d'impulsions chaque fois que le niveau de la tension continue d'alimentation fourni par le circuit de redressement de courant devient inférieure à une valeur prédéterminée de la tension de référence, ce qui permet de maintenir le système bidirectionnel bloqué tant que la tension continue d'alimentation n'a pas atteint la valeur de la tension de référence. Au moment où l'égalité se produit entre le niveau de la tension continue d'alimentation et la valeur de la tension de référence, le circuit de comparaison fournit au moyen de blocage un signal de libération du générateur d'impulsions.

Le circuit interrupteur délivre également, sur une autre borne d'entrée du moyen de blocage, un signal de mise en marche du générateur d'impulsions. Ainsi, le signal appliqué à la borne de commande du générateur d'impulsions est une combinaison, réalisée par le moyen de blocage, des signaux fournis respectivement par le circuit de comparaison et le circuit interrupteur, étant entendu que le générateur d'impulsions ne peut être mis en fonctionnement que si le circuit interrupteur est en position fermée et que la tension continue d'alimentation a atteint la valeur de la tension de référence.

Selon un mode de réalisation particulier de l'invention, le système bidirectionnel comportant l'interrupteur semiconducteur est un triac et une borne de sortie du générateur d'impulsions est reliée à la gâchette du triac.

Enfin, il est à noter qu'une caractéristique avantageuse de l'invention est que, du fait que la présence du circuit de comparaison, le circuit de redressement de courant fournit une tension d'alimentation stable dans le temps, ce qui permet d'envisager de munir à volonté le dispositif selon l'invention de circuits complexes à mémoire. En particulier, on peut prévoir que le circuit interrupteur soit constitué par une bascule bistable marche-arrêt commandée par un système électronique de temporisation offrant à l'utilisateur la possibilité de programmer à l'avance la durée de fonctionnement de la charge placée en série avec le système bidirectionnel.

Les caractéristiques et avantages de l'invention seront bien compris à la lecture de la description qui va suivre, relative à des exemples de réalisation non limitatifs, en regard des dessins annexés dans lesquels :

la figure 1 est le schéma de principe d'un mode de réalisation du dispositif selon l'invention.

La figure 2 est le schéma de principe d'un circuit interrupteur du dispositif de la figure 1 muni d'un système électronique de temporisation.

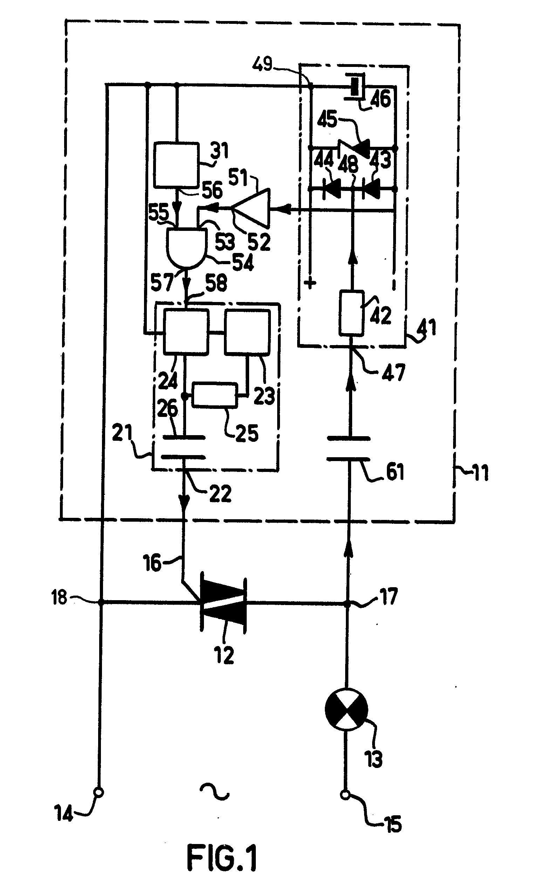

Un dispositif 11 de commande de la gâchette d'un élément interrupteur d'un système bidirectionnel, qui dans le mode de réalisation montré à la figure 1 est un triac 12, est représenté à l'intérieur du cadre en tirets de la figure 1.

Le triac 12 est disposé en série sur le réseau avec une charge, par exemple une lampe 13, la tension-secteur étant appliquée entre les bornes 14 et 15. La gâchette 16 du triac 12 est reliée à la borne 22 de sortie du générateur 21 d'impulsions constitué, selon le mode de réalisation représenté sur la figure 1, par un détecteur 23 de passage par zéro, un amplificateur 24 de sortie et un réseau constitué par une résistance 25 et un condensateur 26, ledit réseau fixant la fréquence de récurrence dudit générateur d'impulsions. Un circuit interrupteur 31 permet à l'utilisateur de commander la mise en fonctionnement du générateur 21 d'impulsions. Une tension continue d'alimentation est fournie par un circuit 41 de redressement de courant comportant une résistance 42 de limitation des tensions-crête, un élément redresseur constitué par les diodes 43, 44, 45, et un condensateur 46 électrochimique de filtrage et d'accumulation d'énergie. Une première borne 47 d'entrée du circuit de redressement de courant est couplée à un premier pôle 17 du triac 12 par un condensateur 61 dont le rôle sera précisé ultérieurement, tandis qu'une deuxième borne 49 d'entrée du circuit 41 de redressement de courant est connectée à un deuxième pôle 18 du triac 12.

Conformément à l'invention, le dispositif 11 comporte un circuit 51 de comparaison du niveau de ladite tension continue d'alimentation à la valeur d'une tension de référence. Une borne 52 de sortie dudit circuit de comparaison délivre, sur une borne 53 d'entrée d'un moyen de blocage des signaux appliqués à la gâchette 16 du triac 12, moyen qui dans l'exemple de réalisation de la figure 1 est une porte logique 54, un signal de mise hors fonctionnement du générateur 21 d'impulsions chaque fois que le niveau de la tension continue d'alimentation devient inférieure à la valeur de la tension de référence. Par une borne 56 de sortie, le circuit interrupteur 31 fournit sur une autre borne 55 d'entrée de la porte logique 54 un signal de mise en marche du dispositif selon l'invention. Le signal issu de la borne 57 de sortie de la porte logique 54 est ensuite appliqué à une borne 58 de commande du générateur 21 d'impulsions ; ce dernier ne peut alors être mis en fonctionnement que lorsque le circuit interrupteur 31 est fermé et que la tension continue d'alimentation a atteint la valeur de la tension de référence.

Comme on peut l'observer sur la figure 1, un condensateur 61 a été disposé entre la borne 47 d'entrée du circuit 41 de redressement de courant et le pôle 17 du triac 12.

Cette configuration permet, en effet, d'obtenir une impédance variable avec le régime de fonctionnement : quand le triac 12 est non-conducteur, l'impédance à 50 Hz du condensateur 61 est relativement élevée, ce qui assure, avec une très faible consommation d'énergie, la chute de la tension-secteur à l'entrée 47 du circuit 41 de redressement de courant. Par contre, lorsque le triac 12 est conducteur, l'impédance du condensateur 61 devient plus faible compte tenu du régime de fronts raides qui apparaît au moment du passage triac non-conducteur-triac conducteur, ce qui est particulièrement favorable puisque la diminution de l'impédance du condensateur 61 coïncide alors avec la diminution de la tension appliquée à l'entrée du circuit 41 de redressement de courant.

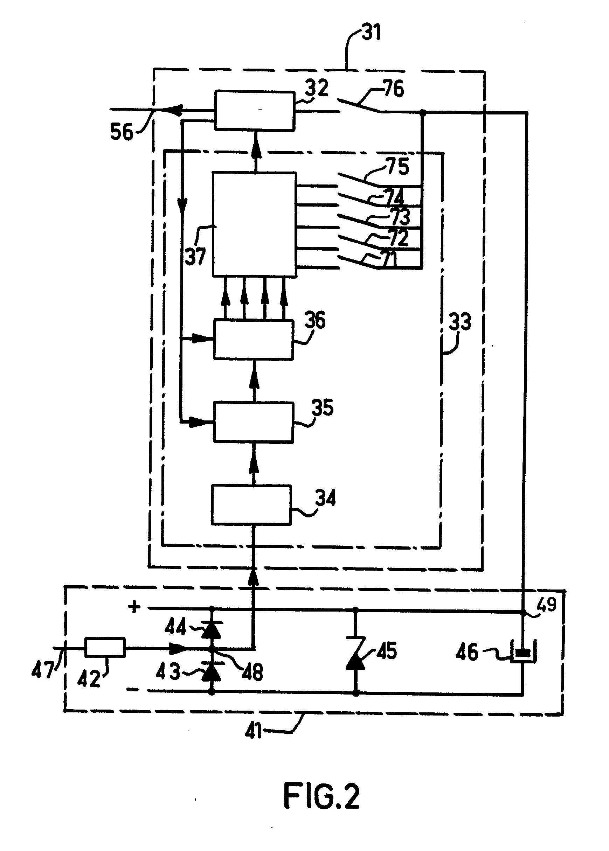

La figure 2 représente le schéma de principe d'un circuit interrupteur 31 constitué par une bascule 32 bistable marche-arrêt associée à un système électronique 33 de temporisation. Cette configuration est rendue possible car, selon une caractéristique avantageuse de l'invention, la tension continue débitée par le circuit 41 de redressement de courant est suffisamment stable pour pouvoir alimenter des circuits logiques complexes. Les évolutions dans le temps du signal issu de la borne 48 du circuit de redressement de courant sont filtrées à 50 Hz et mises sous forme de signaux carrés par le filtre 34. Cette opération est destinée à éliminer les fréquences des perturbations radioélectriques superposées au secteur. Les signaux carrés issus du filtre 34 sont alors appliqués aux compteurs-diviseurs 35, 36 composés d'une série de bascules bistables assurant la division de la fréquence-secteur de façon à retrouver en sortie les informations « seconde », « minute » et « heure ». L'état des compteurs-diviseurs 35, 36 est ensuite comparé, à l'aide du comparateur 37, aux informations matérialisées par la position des clés 71, 72, 73, 74, 75 qui permettent de programmer la durée de temporisation. Quand les informations fournies par les compteurs-diviseurs 35, 36 et les clés 71, 72, 73, 74, 75 sont égales, la bascule 32 bistable marche-arrêt délivre, par la borne 56 de sortie, un signal de mise hors fonctionnement du générateur 21 d'impulsions montré à la figure 1. L'utilisateur peut donner un ordre de remise en marche du générateur d'impulsions à l'aide de l'interrupteur fugitif 76. Les compteurs-diviseurs 35, 36 sont alors remis à zéro et le triac reçoit à nouveau des impulsions de commande pendant une durée prédéterminée par la position des clés 71, 72, 73, 74, 75.

Dans une variante de réalisation du circuit interrupteur 31, l'interrupteur fugitif 76 est remplacé par un dispositif de commutation optoélectronique, par exemple une barrière lumineuse.

Par ailleurs, le circuit interrupteur 31 peut également être constitué par une bascule bistable marche-arrêt associée à un système thermostatique, par exemple un régulateur de convecteur pour le chauffage électrique.

L'invention ne saurait être limitée au dispositif décrit, mettant en œuvre un type particulier de générateur d'impulsions 21, mais elle peut également être mise en œuvre à l'aide d'autres générateurs d'impulsions connus comme, par exemple celui formé par la combinaison d'un circuit oscillateur associé à des portes logiques. Elle ne saurait non plus être limitée à l'utilisation d'un triac en tant que système bidirectionnel ; d'autres éléments interrupteurs semiconducteurs tels que des thyristors montés tête-bêche pouvant également constituer un système bidirectionnel.

## Revendications

1. Dispositif (11) de commande de la gâchette (16) d'un interrupteur semiconducteur d'un système bidirectionnel, une borne (22) de sortie du dispositif (11) de commande étant connectée à la gâchette (16) de l'interrupteur semiconducteur, l'interrupteur étant disposé en série avec une charge (13) alimentée par le secteur, ledit dispositif (11) comportant un générateur (21) d'impulsions dont la sortie est connectée à la gâchette (16) de l'interrupteur semiconducteur, un circuit interrupteur (31) qui permet de commander la mise en fonctionnement du générateur d'impulsions, et un circuit (41) de redressement de courant à accumulateur d'énergie fournissant une tension continue d'alimentation au générateur d'impulsions et au circuit interrupteur, une première borne (47) d'entrée du circuit (41) de redressement de courant étant couplée à un premier pôle (17) du système bidirectionnel, tandis qu'une deuxième borne (49) d'entrée du circuit (41) de redressement de courant est connectée à un deuxième pôle (18) du système bidirectionnel, caractérisé en ce que le dispositif (11) comporte un circuit (51) de comparaison du niveau de la tension continue d'alimentation à la valeur d'une tension de référence, et un moyen de blocage (54) des signaux appliqués à la gâchette de l'interrupteur semiconducteur quand la tension continue d'alimentation est inférieure à la tension de référence.

2. Dispositif selon la revendication 1, caractérisé en ce que le système bidirectionnel comportant l'interrupteur semiconducteur est un triac (12) et en ce que une borne (22) de sortie du générateur (21) d'impulsions est reliée à la gâchette (16) du triac (12).

3. Dispositif selon l'une des revendications 1 ou 2, caractérisé en ce que le circuit interrupteur (31) est constitué par une bascule bistable marche-arrêt (32) commandée par un système électronique (33) de temporisation.

## Claims

1. A device (11) for controlling the gate electrode (16) of a semiconductor interruptor of a bidirectional system, an output terminal (22) of the control device (11) being connected to the gate electrode (16) of the semiconductor interruptor, the interruptor being arranged in series with a load (13) fed by the mains, the said device (11) comprising a pulse generator (21), the output of which is connected to the gate electrode (16) of the semiconductor interruptor, an interruptor circuit (31) which permits of controlling the triggering of the pulse generator and a current rectifying circuit (41) comprising an energy accumulator delivering a direct supply voltage to the pulse generator and to the interruptor circuit, a first input terminal (47) of the current rectifying circuit (41) being coupled to a first pole (17) of the bidirectional system, while a second input terminal (49) of the current rectifying circuit (41) is connected to a second pole (18) of the bidirectional system, characterized in that the device (11) comprises a circuit (51) for comparing the level of the direct supply voltage with the value of a reference voltage and a means (54) for blocking the signals applied to the gate electrode of the semiconductor interruptor when the direct supply voltage is lower than the reference voltage.

2. A device as claimed in Claim 1, characterized in that the bidirectional system comprising the semiconductor interruptor is a triac (12) and in that an output terminal (22) of the pulse generator (21) is connected to the gate electrode (16) of the triac (12).

3. A device as claimed in any one of Claims 1 or 2, characterized in that the interruptor circuit (31) is constituted by a bistable start/stop trigger circuit (32) controlled by an electronic timing system (33).

**Ansprüche**

1. Steuervorrichtung (11) für die Triggerelektrode (16) eines Halbleiterschalters eines bidirektionalen Systems, wobei ein Ausgangsanschluss (22) der Steuervorrichtung (11) mit der Triggerelektrode (16) des Halbleiterschalters verbunden ist, der mit einer netzgespeisten Belastung (13) in Serie geschaltet ist, wobei die Steuervorrichtung (11) einen Impulsgeber (21), dessen Ausgang an die Triggerelektrode (16) des Halbleiterschalters angeschlossen ist, einen Schaltkreis (31) zum Steuern des Betriebs des Impulsgebers, und einen Stromgleichrichter (41) mit einem Energiespeicher enthält, der den Impulsgeber und den Schaltkreis mit einer Speisegleichspannung beliefert, wobei ein erster Eingangsanschluss (47) des Stromgleichrichters an einen ersten Pol (17) des bidirektionalen Systems angeschlossen ist, während ein zweiter Eingangsanschluss (49) des Stromgleichrichters (41) mit einem zweiten Pol (18) des bidirektionalen Systems verbunden ist, dadurch gekennzeichnet, dass die Steuervorrichtung (11) enthält: eine Vergleichsschaltung (51) zum Vergleichen des Pegels der Speisegleichspannung mit dem Wert einer Bezugsspannung und eine Sperre (54), die an die Triggerelektrode des Halbleiterschalters angelegte Signale blockiert, wenn die Speisegleichspannung niedriger als die Bezugsspannung ist.

2. Steuervorrichtung nach Anspruch 1, dadurch gekennzeichnet, dass das bidirektionale System mit dem Halbleiterschalter ein Triac (12) ist und dass ein Ausgangsanschluss (22) des Impulsgebers (21) an die Triggerelektrode (16) des Triacs (12) angeschlossen ist.

3. Steuervorrichtung nach einem der Ansprüche 1 oder 2, dadurch gekennzeichnet, dass der Schaltkreis (31) eine bistabile Ein/Aus-Stufe (32) ist, die von einem elektronischen Verzögerungssystem (33) gesteuert wird.

FIG.1

FIG.2